(19) Europäisches Patentamt / European Patent Office / Office européen des brevets

(11) **EP 3 790 057 A1**

(12) **EUROPEAN PATENT APPLICATION**

(43) Date of publication:
**10.03.2021 Bulletin 2021/10**

(51) Int Cl.:
*H01L 29/786* (2006.01)   *H01L 21/336* (2006.01)

(21) Application number: **19195950.1**

(22) Date of filing: **06.09.2019**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **SABIC Global Technologies B.V.
4612 PX Bergen op Zoom (NL)**

(72) Inventors:
• **NAYAK, Pradipta K.
23955-6900 Thuwal (SA)**
• **AL-MAGHATHUWI, Ramzi Salem
23955-6900 Thuwal (SA)**

(74) Representative: **Elzaburu S.L.P.
Miguel Angel 21, 2nd floor
28010 Madrid (ES)**

(54) **LOW TEMPERATURE PROCESSED SEMICONDUCTOR THIN-FILM TRANSISTOR**

(57)   A method of forming a thin-film device is disclosed. An example method comprises forming a thin-film gate electrode layer, forming a thin-film gate insulator layer adjacent to the thin-film gate electrode layer, and forming a thin-film semiconductor bi-layer adjacent to the thin-film gate insulator layer. The thin-film semiconductor bi-layer comprises a first layer and a second layer. The first layer comprises indium zinc oxide and has a thickness of about 1 nm to about 10 nm. The second layer comprises indium gallium zinc oxide and has a thickness of about 15 nm to about 50 nm. The method comprises applying a pre-annealing process to one or more of the first layer or the second layer prior to forming a source-drain electrode. The thin-film gate electrode layer, the thin-film gate insulator layer, and the thin-film semiconductor bi-layer are formed in a temperature range of about 20°C to about 250°C.

FIG. 1

EP 3 790 057 A1

**Description**

**TECHNICAL FIELD**

The disclosure generally relates to thin-films, and more particularly to thin-film transistor devices comprising semiconductor metal oxides.

**BACKGROUND**

Thin-film transistors (TFTs) are the building blocks of various electronic devices. In particular, TFTs are widely used for pixel driving in flat-panel displays. TFTs are also very useful for low cost integrated circuits (ICs), radio frequency identifications (RF-IDs), smart cards and sensing applications. In the past decade various metal oxide based semiconductors have been explored as alternative semiconductor to the low mobility (e.g., less than about 1 $cm^2$/Vs) amorphous silicon commonly used as the channel layer in thin-film transistors. Metal oxide semiconductor based thin-film transistors have several advantages over amorphous silicon based thin-film transistors, such as high field-effect mobility, low off-state current, high subthreshold swing and high transparency. In particular, TFTs with metal oxide semiconductors as channel layers are advantageous because of their low power consumption, high driving performance and a high response rate. TFTs with field-effect mobility (e.g., greater than about 10 $cm^2$/Vs) have been reported using indium gallium zinc oxide and other oxide based semiconductors as active channel layers. Currently, indium gallium zinc oxide based TFTs are being used for pixel driving in flat-panel displays by several leading display industries. However, in most cases, high process temperature (e.g., greater than about 350°C) is used to get better and reliable TFT performance. The high process temperature used in these cases does not allow fabricating TFTs on low cost plastic substrates with a mechanical flexible form factor. Although, TFTs with field-effect mobility about 10 $cm^2$/Vs is appropriate for most display applications, higher mobility TFTs are necessary for many other applications such as in pixel driving circuits, low cost ICs and high frequency active communications. Further, in most of the reported research publications, the TFTs are operated in the high voltage range (e.g., greater than about 15 V), which is not suitable for low-power consumption electronic devices such as ICs, RF-IDs and sensors. This is especially true in the emerging internet of things (IoT) application area where voltages below 5 V are needed to operate circuitry. Thus, there is a need for improved thin-film transistors.

**SUMMARY**

A thin-film device comprises a thin-film transistor. The thin-film transistor comprises a substrate, a thin-film gate electrode layer adjacent to the substrate, a thin-film gate insulator layer adjacent to the thin-film gate electrode layer and comprising hafnium oxide, and a thin-film semiconductor bi-layer adjacent to the thin-film gate insulator layer. The thin-film semiconductor bi-layer comprises a first layer and a second layer. The first layer comprises indium zinc oxide with a ratio of indium to zinc in a range of about 19:1 to about 2:1 and the second layer comprises indium gallium zinc oxide with a ratio of indium to gallium to zinc of about 1:1:1. The first layer has a thickness of about 1 nm to about 10 nm and the second layer has a thickness of about 15 nm to about 50 nm. The thin-film transistor comprises a thin-film source-drain electrode layer adjacent to the thin-film semiconductor bi-layer.

An example method comprises forming a thin-film gate electrode layer adjacent to a substrate, forming a thin-film gate insulator layer adjacent to the thin-film gate electrode layer and comprising hafnium oxide, and forming a thin-film semiconductor bi-layer adjacent to the thin-film gate insulator layer. The thin-film semiconductor bi-layer comprises a first layer and a second layer, wherein the first layer comprises indium zinc oxide with a ratio of indium to zinc in a range of about 19:1 to about 2:1 and the second layer comprises indium gallium zinc oxide with a ratio of indium to gallium to zinc of about 1:1:1. The first layer has a thickness of about 1 nm to about 10 nm (e.g., or about 3 nm to about 10 nm, or about 5 nm to about 10 nm) and the second layer has a thickness of about 15 nm to about 50 nm. The method comprises applying a pre-annealing process to one or more of the first layer or the second layer, and after applying the pre-annealing process, forming a thin-film source-drain electrode layer adjacent to the thin-film semiconductor bi-layer. The thin-film gate electrode layer, the thin-film gate insulator layer, and the thin-film semiconductor bi-layer, and the second thin-film electrode layer are formed in a temperature range of about 20°C to about 250°C.

Additional advantages will be set forth in part in the description which follows or can be learned by practice. It is to be understood that both the foregoing general description and the following detailed description are exemplary and explanatory only and are not restrictive.

**BRIEF DESCRIPTION OF THE DRAWINGS**

The above-mentioned and other features and advantages of this disclosure, and the manner of attaining them, will become apparent and be better understood by reference to the following description of one aspect of the disclosure in conjunction with the accompanying drawings, wherein:

FIG. 1 is a diagram showing an example device in accordance with the present disclosure.

FIG. 2 shows transfer characteristics of thin-film transistors (TFTs) with InZnO semiconductor layer deposited at different oxygen partial pressure.

FIG. 3 shows transfer characteristics of TFTs with different InZnO semiconductor layer thickness deposited at 4.0% Opp.

FIG. 4A shows transfer characteristics of InZnO TFTs measured after 6 hours and 18 hours of post-fabrication annealing without passivation layer.

FIG. 4B shows transfer characteristics of InZnO TFTs with a Parylene-C passivation layer.

FIG. 5 shows transfer characteristics of TFTs with InZnO-InGaZnO as a thin-film semiconductor bi-layer, post annealead at 180 °C.

FIG. 6 shows transfer characteristic curves of TFTs with InZnO (6nm)-InGaZnO (25nm) as the thin-film semiconductor bi-layer and post-annealed at 180°C, 225°C and 250°C.

FIG. 7 shows transfer characteristics of TFTs with a thin-film semiconductor bi-layer having 6 nm of InZnO layer and different thicknesses of InGaZnO layer.

FIG. 8A shows transfer characteristics of TFTs having no pre-annealed InZnO-InGaZnO layer before the source-drain patterning and deposition.

FIG. 8B shows transfer characteristics of TFTs having a pre-annealed InZnO-InGaZnO layer before the source-drain patterning and deposition.

FIG. 9 shows optical images of InZnO-InGaZnO thin-film transistors having different thickness and resulting damage.

FIG. 10A shows the transfer characteristic curves of InZnO-InGaZnO TFT measured after 12 hours and 2 days of post-fabrication annealing.

FIG. 10B shows the transfer curves of InZnO-InGaZnO TFTs measured under different durations of positive gate bias stress

## DETAILED DESCRIPTION

The present disclosure relates to a novel process to fabricate thin-film devices, such as thin-film transistors. An example device comprises a semiconductor bi-layer, such as a bi-layer of indium zinc oxide-indium gallium zinc oxide. The device comprises a thin-film gate insulator layer. The thin-film gate insulator layer can comprise a material compatible with both rigid and flexible plastic substrates. The use of a thin-film semiconductor bi-layer enables lower turn-on voltage and improves the stability of TFTs. Atomic layer deposition may be used to form a thin-film gate insulator layer (e.g., comprising hafnium oxide). By carefully controlling the process conditions (e.g., using lower process temperatures) of the thin-film semiconductor bi-layer and using appropriate source drain electrode material, a device may be formed that exhibits high field-effect mobility and operates in the low voltage operation with better stability having no passivation layer.

The thin-film semiconductor bi-layer comprises a metal oxide based semiconductor material. The thin-film semiconductor bi-layer can be used as active channel layers of the thin-film transistor. The thin-film semiconductor bi-layer can comprise a metal oxide semiconductor material, such as zinc oxide (ZnO), indium oxide ($In_2O_3$), indium zinc oxide (InZnO), zinc tin oxide (ZTO), indium gallium zinc oxide (InGaZnO). Metal oxide semiconductor material based TFTs can exhibit field-effect mobility of about 10 cm$^2$/Vs. Although, TFTs with field-effect mobility of about 10 cm$^2$/Vs are appropriate for most display applications, however, high mobility TFTs may be necessary for other applications such as in pixel driving circuits, low cost ICs and high frequency active communications. TFTs with field-effect mobility of greater than about 50 cm$^2$/Vs can be obtained using InZnO and InZnO-InGaZnO based thin-film semiconductor bi-layer layer as active channel layer. However, it should be noted that the mobility values in some publications have been over estimated by not taking the right device structure and other parameters into account while extracting the mobility values. In addition, in most cases the thin-film gate insulator layer is deposited at higher temperature to lower the defects in the thin-film gate insulator layer and to achieve better TFT performance. Silicon dioxide ($SiO_2$) and silicon nitride ($SiN_x$) have been extensively used for thin-film gate insulator layers in metal oxide semiconductor TFTs. In these cases, both $SiO_2$ and $SiN_x$ materials have been predominantly prepared by plasma enhanced chemical vapor deposition technique at a relatively high temperature of greater than about 300°C (e.g., or about 350°C) to get good quality and defect free results. Use of high temperature of greater than about 300°C (e.g., or about 350°C) may not be suitable for building TFTs on plastic substrates for flexible electronic applications and also the fabrication process is not cost effective as it will consume more energy.

Thin-film gate insulator layers comprising low-k dielectrics such as $SiO_2$ and $SiN_x$ typically requires high voltages to operate and consume more power. However, TFTs with high performance in the low voltage operation are very important for low-power consumption electronic devices. Especially, ICs, RF-IDs, sensors and IoT applications require low voltage operation (e.g., less than about 5 V). For faster response/switching, the oxide TFTs should exhibit low subthreshold swing (SS) value (e.g., about 100mV/decade), which is defined as the voltage required to increase the magnitude of current between drain and source electrode by ten times of its initial value in the subthreshold range of the transistor operation. Thin-film gate insulator layers with high-k dielectrics can be used for low subthreshold swing and low voltage operation of the TFTs. However, high-k dielectric when deposited at low processing temperatures does not exhibit good performance. Low temperature processed thin-film gate insulators can possess a large number of defects, which can also affect the quality of an adjacent to thin-film semiconductor bi-layer and the interface between the thin-film gate insulators and thin-film semiconductor bi-layer. In particular, oxide TFTs using hafnium oxide as gate insulator, deposited by sputtering technique typically show very low performance and reliability. However, the disclosed techniques allow for improvement over conventional approaches.

Although, TFTs with good performance have been reported in many research publications, they possess several disadvantages, such as the following: thin-film gate insulators are deposited at high temperature, high post fabrication annealing temperature (e.g., greater than about 300°C or greater than about 350°C) used to improve performance, high processing temperature leads to high energy consumption and thus expensive, high process temperature limit the use of cheap flexible substrates, use of dry etching of semiconductor layer patterning increases cost, requires an etch stopper layer to stop the plasma damage during semiconductor etching process, low field-effect mobility and unstable performance for devices at low processed temperature, high subthreshold swing value not suitable for faster response time, and high voltage range of operation not suitable for internet of things (IoT), low cost ICs, RFID applications. The disclosed techniques address the problems with conventional devices described above.

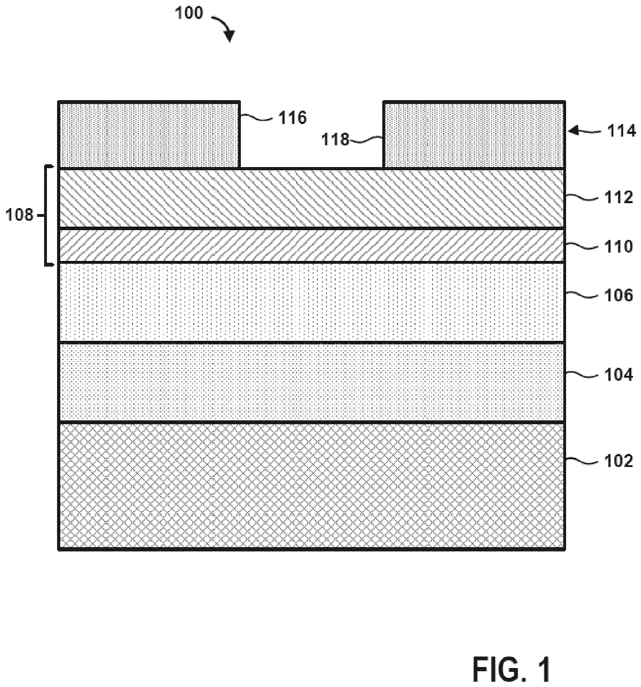

FIG. 1 shows an example device 100 in accordance with the present disclosure. The device 100 comprises a thin-film device, a thin-film transistor, and/or the like. The device 110 comprises one or more layers. The one or more layers can comprise one or more thin-film layers. The one or more thin-film layers can be formed using thin-film deposition techniques. The device 100 (e.g., the thin-film transistor) is formed (e.g., using one or more process) in a temperature range of below one or more of about 250°C, about 200°C, about 150°C, or about 100°C. The device 100 can be formed using one or more deposition process, annealing process, pre-annealing process, passivation processing, and/or combination thereof within the temperature range.

The term thin-film as used herein in association with a layer indicates that the layer is a thin-film layer. A thin-film layer can be a monolayer (e.g., or multiple layers). A thin-film layer can have a thickness of within a range of from about a nanometer to about several micrometers (e.g., or about several hundred micrometers). A thin-film layer can have a thickness of one or more of: about 1 nm to about 5 nm, about 1 nm to about 10 nm, about 1 nm to about 15 nm, about 15 nm to about 50 nm, about 1 nm to about 50 nm, about 1 nm to about 75 nm, about 1 nm to about 100 nm, about 1 nm to about 150 nm, about 1 nm to about 50 nm, or a combination thereof. The thickness of a thin-film layer can depend on end application needs, power consumption design (e.g., low power battery driven), a combination thereof, and/or the like.

The device 100 comprises a substrate 102. The substrate 102 can be formed or obtained from a manufacturer. The substrate 102 can be (e.g., or comprise) a thin-film layer. The substrate 102 can comprise an insulating material, such as a rigid glass or flexible plastic material. For flexible substrates, the substrate 102 may comprise a plastic substrates (e.g., that can withstand the temperature range), such as polyimide (PI), polyethylene naphthalate (PEN), polyetherimide (PEI) or polyethylene terephthalate (PET). A barrier layer may be used to prevent penetration of water and/or oxygen molecules from the substrate 102 to the other layers (e.g., the thin-film transistor layers) of the device 102. Example barrier layer materials can comprise $Al_2O_3$, $HfO_2$, $SiO_2$, $SiN_x$, a combination thereof, and/or the like.

The device 100 comprises a thin-film gate electrode layer 104 (e.g., or gate layer). The thin-film gate electrode layer 104 is disposed adjacent to the substrate 102. As used herein, the term adjacent when used in relation to a layer can comprise next to, in contact with, above, on top of, below, coupled to, or a combination thereof. The term adjacent can allow for one or more intervening layers between two layers that are adjacent. The terms above, below, and on top of when used in relation to one layer being above, below, or on top of another layer (e.g., or material stack of layers) is specific to the orientation shown in the figures of the present application (e.g., FIG. 1) in which layers are shown vertically stacked in a vertical direction from the bottom of the figures to the top of the figures. A layer that is above another layer is vertically higher than the other layer according to the orientation shown in the figures (e.g., is shown closer to the top of the figures than the other layer). A layer that is below another layer is vertically lower than the other layer according to the orientation shown in the figures (e.g., is shown closer to the bottom of the figures than another layer). A layer that is on top of another layer is above the other layer and has at least a portion of a bottom surface in contact with at least a portion of a top surface of the other layer. It should be understood that if the layers of an implemented device are rotated to a different orientation than the orientation shown, the layers in the different orientation are still understood to be above, below, or on top of another layer if such relationship applies when oriented in the manner shown in the figures of the present application.

The thin-film gate electrode layer 104 can comprise a layer of conducting thin-film. The thin-film gate electrode layer 104 can comprise aluminum-doped zinc oxide. The thin-film gate electrode layer 104 can comprise other transparent conducting oxides, such as tin-doped indium oxide (ITO), gallium-doped zinc oxide (GZO), hafnium doped zinc oxide (HZO), tin dioxide ($SnO_2$), Fluorine-doped tin oxide (FTO), tantalum nitride, or a combination thereof. The thin-film gate electrode layer 104 can comprise a conducting metal, such as aluminum (Al), chromium (Cr), titanium (Ti), molybdenum (Mo), nickel (Ni), silver (Ag), zinc (Zn), or a combination thereof. The thin-film gate electrode layer 104 can have a thickness in a range of about 50 nm to about 200 nm.

The device 100 comprises a thin-film gate insulator layer 106 (e.g., gate dielectric layer). The thin-film gate insulator layer 106 is disposed adjacent to (e.g., disposed on top of) the thin-film gate electrode layer 104. The thin-film gate insulator layer 106 comprises hafnium oxide ($HfO_2$). The thin-film gate insulator layer 106 can be deposited by an atomic layer deposition (ALD) process. The thin-film gate insulator layer 106 can be formed (e.g., using the ALD process) in a temperature range of about 100°C to about 250°C. The thin-film gate insulator layer 106 can be deposited by ALD using water, hydrogen peroxide ($H_2O_2$) or ozone as the source of oxygen. The thickness of the thin-film gate insulator layer 106 can be in a range of about 25 nm to about 110 nm. A post deposition annealing of the thin-film gate insulator layer 106 (e.g., in air or oxygen ambient) can be performed in a temperature range of about 100°C to about 250°C (e.g., to reduce the defects in the surface and bulk of the thin-film gate insulator layer 106, which can improve the TFT performance).

The device 100 comprises a thin-film semiconductor bi-layer 108. The thin-film semiconductor bi-layer 108 is disposed adjacent to the thin-film gate insulator layer 106. The thin-film semiconductor bi-layer 108 can comprise a first layer 110. The first layer 110 can comprise a first metal oxide semiconductor material. The one or more semiconductor layers 108 can comprise a second layer 112. The second layer 112 can comprise a second metal oxide semiconductor material.

The first layer 110 (e.g., or first metal oxide semiconductor material) comprises indium, zinc, or a combination thereof. The first layer 110 comprises indium zinc oxide (InZnO). The first layer 110 comprises indium and zinc in a ratio (e.g., molar ratio) that is in a range of about 19:1 to about 2:1. The ratio of indium to zinc can be in a range of one or more of about 18:1 to about 3:1, about 16:1 to about 4:1, about 14:1 to about 5:1, about 12:1 to about 6:1, about 10:1 to about 8:1, and/or the like. The ratio of indium to zinc can be in a range of one or more of about 19:1 to about 6:1, about 19:1 to about 7:1, about 19:1 to about 5:1, about 19:1 to about 8:1, and/or the like. The ratio of indium to zinc can be about 9:1. The second layer 112 (e.g., the metal oxide semiconductor material) comprises indium, zinc, gallium, or a combination thereof. The second layer 112 comprises indium gallium zinc (InGaZnO). The second metal oxide semiconductor material can comprise indium and zinc in a ratio of about 1:1:1.

The thin-film semiconductor bi-layer 108 comprises InZnO, InGaZnO, or a combination thereof (e.g., In:Zn ratio of 9:1 and In:Ga:Zn ratio of 1:1:1). The thin-film semiconductor bi-layer 108 can comprise a metal oxide semiconductor comprising indium, zinc, gallium, or a combination thereof. The first layer 110 can comprise a high mobility layer (e.g., can have materials selected to optimize and/or increase mobility). The first layer 110 can have a higher mobility than the second layer 112. The second layer 112 can have higher stability than the first layer 110. The first layer 110 (e.g., InZnO) can be first deposited on the thin-film gate insulator layer 106. The second layer 112 (e.g., InGaZnO) can be deposited on top of the first layer 110. The second layer 112 can have a thickness that is larger than the thickness of the first layer 110.

The thin-film semiconductor bi-layer 108 can be deposited by a radio frequency sputtering process, DC-sputtering, PECVD, ALD, a combination thereof, or any other solution deposition process. The thickness of the first layer 110 is in a range of about 1 nm to about 10 nm. The thickness of the second layer 112 is in a range of about 15 nm to about 50 nm. The thin-film semiconductor bi-layer 108 can be formed by wet etching the first layer 110 and the second layer 112.

The device 100 comprises a thin-film source-drain electrode layer 114. The thin-film source-drain electrode layer 114 can be disposed adjacent to the thin-film semiconductor bi-layer 108. The thin-film source-drain electrode layer 114 can comprise a source 116 and a drain 118. The thin-film source-drain electrode layer 114 (e.g., the source 116, the drain 118) can comprise a conducting material, such as chromium (Cr), molybdenum (Mo), nickel (Ni), titanium (Ti), or a combination thereof. The thin-film source-drain electrode layer 114 (e.g., the source 116, the drain 118) can comprise a transparent conducting oxide, such as aluminum-doped zinc oxide (AZO), tin-doped indium oxide (ITO), gallium-doped zinc oxide (GZO), hafnium-doped zinc oxide (HZO), tin dioxide ($SnO_2$), Fluorine-doped tin oxide (FTO), tantalum nitride.

The thin-film source-drain electrode layer 114 (e.g., the source 116, the drain 118) can comprise a bi-layer of one or more conducting materials, such as titanium and gold. The bi-layer of the thin-film source-drain electrode layer 114 can comprise a first conductive layer adjacent to (e.g., disposed on top of) the thin-film semiconductor bi-layer 108 and a second conductive layer adjacent to (e.g., disposed on top of) the first conductive layer. The first conductive layer can have a first work function. The second layer 112 of thin-film semiconductor bi-layer 108 can have a second work function. The first work function can have a value that is the same or within about 20 percent greater than the second work function. For example, the work function for InGaZnO for the second layer 112 can be in a range of about 3.8eV to about 4.3eV. The work function of the first conductive layer of the thin-film source-drain electrode layer 114 can be in a range of about 3.8eV to about 5.2eV. The first conductive layer can have a thickness in a range of one or more of about 3 nm to about 30 nm or about 5 nm to about 10 nm. The second conductive layer can have thickness in a range of about 30 nm to about 200 nm. The first conductive layer can comprise titanium and the second conductive layer can comprise gold.

The device 100 can be formed using a low temperature process. The thin-film gate electrode layer, the thin-film gate insulator layer, and the thin-film semiconductor bi-layer are formed in a temperature range of about 20°C to about 250°C. Forming the thin-film gate insulator layer 106 can be performed in a temperature range of about 100°C to about 250°C. The device 100 (e.g., or thin-film transistor, the thin-film gate electrode layer 104, the thin-film gate insulator layer 106, the thin-film semiconductor bi-layer 108) can be formed using a maximum temperature in a temperature range of one or more of: about 100°C to about 150°C, about 150°C to about 200°C, 200°C to about 250°C.

The device 100 can be formed by applying one or more annealing processes, such as a pre-annealing process, a post fabrication annealing, or a combination thereof. The pre-annealing process can be applied to one or more of the first layer 110 or the second layer 112. The one or more annealing processes can be performed in the temperature range of one or more of: about 125°C to about 175°C, about 175°C to about 225°C, 200°C to about 250°C, or about 125°C to about 250°C.

The post fabrication annealing process can comprise using a conventional furnace in air environment (e.g., or under pure oxygen or oxygen containing environment). The post fabrication annealing process can be performed in a temperature range of about 100°C to about 250°C. Photo-annealing/curing in air or oxygen ambient can also be performed (e.g., for rapid thermal processing to improve the device performance). The device 100 (e.g., thin-film transistor) can be formed with or without a passivation layer.

The device 100 can be configured as a thin-film transistor. The transistor operation can be performed by applying an appropriate voltage greater than the threshold voltage of the transistor to the thin-film gate electrode layer 104 to accumulate or deplete carriers at the interface of the thin-film gate insulator layer 104 and the thin-film semiconductor bi-layer 108 and thereby changing the magnitude of current between the source and drain electrodes.

The device 100 can comprise or be formed according to any of the following novel features. The device 100 can be formed using a processing temperature in range of about 20°C to about 250°C. The device 100 can be formed by forming a thin-film gate insulator layer 104 using a low temperature ALD deposited $HfO_2$. The device 100 can be formed on a rigid and/or flexible plastic substrate.

The device 100 can have the following high performance characteristics. The device 100 can have field-effect mobility (e.g., greater than about $35cm^2/Vs$). The device 100 can have high on-to-off drain current ratio (e.g., greater than about $10^9$). The device 100 can have a subthreshold swing (e.g., about 100 mV/decade). The device 100 can have a low negative turn-on voltage (e.g., about -1 V).

The device 100 can have enhanced device stability without using a passivation layer (e.g., barrier layer). The device 100 can comprise transparent conducting AZO as a gate electrode. Use of AZO can allow control over turn-on voltage (Von). Use of AZO can be low cost as compared to ITO.

The device 100 can be formed by using wet etching of InZnO-InGaZnO thin-film semiconductor bi-layer 108. This approach can eliminate the need for an etch-stopper layer as used in dry-etching process. The wet etching process can be faster than other processes. The wet etching process can be cost-effective, with no need for expensive dry-etching vacuum techniques.

The device 100 can have low voltage operation with low turn-on voltage. The device 100 can be used for integrated circuits, Internet of things (IoT) applications, driving circuits for touch and force sensors, pull-up transistor, analog-to-digital and digital-to-analog convertors, TFT based memory, RF-IDs, oscillators, and power management circuits.

## Examples

In this section, description of the fabrication and characterization of an example device according to the present disclosure are disclosed. Though the following is illustrated using example values, processes, and materials, it is contemplated that other materials, processes, and values can be used according to design specifications.

Thin Film Transistor Fabrication

Step 1: Substrate preparation.

Glass substrates of thickness 1.1 mm were used to build the TFT devices. The glass substrates were sonicated in acetone, isopropanol and deionized water separately and then lastly blown-dried by a high purity nitrogen ($N_2$) gas gun.
It should be understood that other materials can be used, such as materials that can withstand a temperature of about 250°C or below. The material of the substrate can comprise a plastic, such polyimide, polyetherimide, polyethylene naphthalate (PEN), or a combination thereof.

Step 3: Thin-film gate electrode deposition.

Aluminum doped zinc oxide (AZO) thin-film of thickness about 170 nm was used as the gate electrode. The AZO films were deposited on cleaned glass substrates by ALD at 160°C using Diethylzinc (DEZ) and trimethylaluminum (TMA) from Sigma Aldrich as the Zn and Al precursors and DIW as the oxygen precursor. The ratio of DEZ sub-cycle (DIW/$N_2$-purge/DEZ/ $N_2$-purge) to TMA sub-cycle (DIW/ $N_2$-purge /TMA/ $N_2$-purge) was fixed at 20:1 to obtain an AZO film with low sheet resistance (e.g., about 100 Ω/square). The sub-cycle of [(DIW/$N_2$-purge/DEZ/ $N_2$-purge) + (DIW/ $N_2$-purge /TMA/ $N_2$-purge)] was repeated 45 times to obtain a final AZO film with a thickness of about 170 nm. The pulse time of DEZ, TMA and DIW precursor was fixed as 0.015 seconds and 20 standard cubic centimeters per minute (sccm) of $N_2$ gas was used as the process gas.

Step 4: Thin-film gate electrode pattering.

The AZO film was patterned by standard photolithography and wet etching. A 4$\mu$m thick AZ ECI3027 positive photoresist (PR) was first spin coated on top of the AZO film. The PR layer was then exposed with a broadband UV light source at a dose of 200 mJcm$^{-2}$ and then developed using AZ 726 MIF developer to get the desired features of the gate electrode. The unwanted areas of the AZO film were then etched for 35 seconds using diluted (0.5% v/v) hydrochloric acid. After etching the AZO film the PR layer was removed by cleaning with acetone, isopropanol and DIW and finally dried using $N_2$ gas.

Step 5: Thin-film gate insulator layer deposition and post annealing.

Hafnium oxide ($HfO_2$) was used as the thin-film gate insulator layer. The thin-film gate insulator layer was deposited on top of the AZO gate electrodes by ALD technique using tetrakis(dimethylamido)hafnium(IV) from Sigma Aldrich as the Hf precursor and ozone as the oxygen precursor and 90 sccm of Nitrogen gas (e.g., $N_2$ gas) was used as the process gas. Hafnium oxide can also be deposited using water or hydrogen peroxide as the oxygen precursor. The pulse time of tetrakis(dimethylamido)hafnium(IV) and ozone was fixed as 0.2 second and 0.15 second, respectively. The growth temperature for the $HfO_2$ film was 160°C and the films were post-annealed at 120°C in air for 2 hours.

Step 6: Thin-film semiconductor bi-layer deposition.

First, a thin layer of indium zinc oxide (InZnO) was deposited on top of the $HfO_2$ layer and then indium gallium zinc oxide (InGaZnO) layer was deposited on top of InZnO, without breaking the vacuum. Both InZnO and InGaZnO layers were deposited by radio frequency sputtering (Angstrom Engineering) from 2" InZnO and InGaZnO targets, respectively (Super Conductor Materials Inc.) under the deposition conditions as mentioned in Table 1. Table 1 shows deposition conditions for the InZnO-InGaZnO based semiconductor bi-layer deposition.

**Table 1.**

| Deposition Parameters | InZnO layer | InGaZnO layer |
|---|---|---|
| Semiconductor composition | In:Zn = 9:1 | In:Ga:Zn = 1:1:1 |
| Power (Watts) | 25-75 | 25-75 Watts |
| Deposition Pressure (mTorr) | 1 to 4 | 1 to 4 |
| Deposition Temperature (°C) | Room temperature | Room temperature |
| Relative Oxygen Partial Pressure (*Opp*)* | 2.0-5.0% | 2.0-5.0% |
| Thickness (nm) | 3 to 15 | 5 to 50 |
| Pre-sputtering Time (s) | 300 seconds | 300 seconds |

$$*O_{PP} = \frac{\text{Oxygen flow (O2)}}{\text{total flow (Ar+O2)}}$$

Step 7: Thin-film semiconductor bi-layer pre-annealing.

The InZnO and InZnO-InGaZnO layers were annealed at 250°C for 2 hours in air ambient, which helps to minimize the oxidation of the Ti source-drain electrode during the final post fabrication annealing of TFTs and improves performance.

Step 8: Thin-film semiconductor bi-layer patterning.

The InZnO-InGaZnO materials patterned by standard photolithography and wet etching. A 4 $\mu$m AZ ECI3027 positive photoresist (PR) was first spin coated on the InZnO-InGaZnO semiconductor layer. The PR layer was then exposed with a broadband UV light source at a dose of 200mJcm$^{-2}$ and then developed using AZ 726 MIF developer to get the desired features of the thin-film semiconductor bi-layer pattern. The unwanted areas of the InZnO-InGaZnO film were then etched for 120 seconds using diluted (4% v/v) hydrochloric acid. After etching the InZnO-InGaZnO of the thin-film semiconductor bi-layer the PR layer was removed by cleaning with acetone, isopropanol and DIW and finally dried using $N_2$ gas.

Step 9: Thin-film gate electrode layer via patterning.

To create access to the thin-film gate electrode through the thin-film gate insulator layer, via holes were formed by standard photolithography and dry etching. A 4 $\mu$m AZ ECI3027 positive photoresist (PR) was first spin coated on the substrate containing the layers of thin-film gate electrode layer, thin-film gate insulator layer and the thin-film semiconductor bi-layer. The PR layer was then exposed with a broadband UV light source at a dose of 200 mJcm$^{-2}$ and then developed using AZ 726 MIF developer to get the desired features of the via-hole pattern. Then the thin-film gate insulator layer from the gate via pattern was etched by dry etching using CH3 (20 sccm) and Ar gas (4 sscm) plasma with an etching rate of about 55nm/minute. After etching the $HfO_2$ film the remnant PR layer was removed by cleaning with acetone, isopropanol and DIW and finally dried using Nitrogen gas (e.g., $N_2$ gas).

Step 10: Source-drain contact deposition and patterning.

A bi-layer of 10 nm titanium and 60 nm gold source and drain electrodes were patterned using conventional photolithography techniques and electron-beam evaporation deposition. A 4 um-thick AZ ECI3027 positive photoresist (PR) was first spin coated on the substrate containing the layers of the thin-film gate electrode layer, thin-film gate insulator layer and the thin-film semiconductor bi-layer. The PR layer was then exposed with a broadband UV light source at a dose of 200 mJcm$^{-2}$ and a photomask to transfer the desired features. The PR was then developed using AZ 726 MIF developer. Titanium (15 nm) and gold (60 nm) electrodes were then deposited using electron-beam evaporation deposition. Lift-off using acetone was performed to remove the unwanted areas and cleaned in isopropanol and DIW to complete the patterning process.

Step 11: Post-annealing of TFTs.

After the whole fabrication process, the TFTs were annealed in a tube furnace in the temperature range of about 100°C to about 250°C for 2 hours in air ambient to get better performance and stability.

Step 12: Protection layer deposition (Optional):

The thin-film transistors may need an appropriate oxygen and water barrier material, to be protected from ambient effects, which may affect the TFT performance. The protection layer material can be $Al_2O_3$, $HfO_2$, silicon nitride, silicon dioxide, or any other organic materials such as SU-8, parylene, PVP and PVDF, which can protect the channel layer from the ambient effects.

Thin-film transistor characterization

The current and voltage characteristics of TFTs were measured using an Agilent B 1500A semiconductor device parameter analyzer and Cascade Summit 1100 probe station under dark and ambient conditions. Transfer characteristic curves of the TFTs were obtained by sweeping the voltage applied to the gate electrode at a fixed voltage applied to the drain electrode while the source electrode was maintained as the common electrode (grounded).

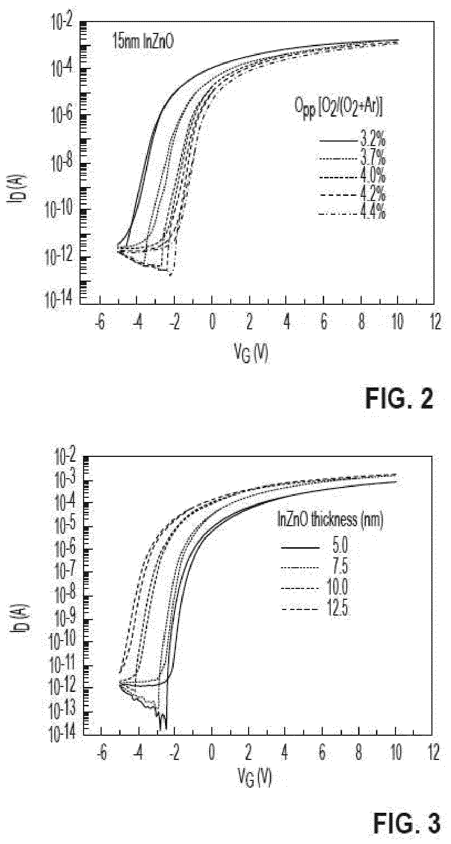

FIG. 2 shows the transfer characteristic curves of InZnO TFTs prepared at different oxygen partial pressures (Opp) with 15 nm of InZnO as active channel layer. The InZnO TFTs were post-annealed at 180°C for 2 hour in air environment. FIG. 2 illustrates how the performance of TFTs varies as a function of change in oxygen partial pressure during sputter deposition of InZnO thin-film. The mobility of the TFTs was extracted in the saturation region of its operation. The turn-on voltage ($V_{on}$) is the voltage from where the drain current ($I_D$) rises rapidly in the logarithmic scale. Based on the extracted electrical parameters as listed in Table 2, TFTs with good performance can be obtained in the Opp range of 4.0-4.2%.

Below 4.0% Opp, $V_{on}$ becomes very negative and above 4.2% Opp, the mobility value decreased.

**Table 2.**

| Opp (%) | Field-effect mobility (cm$^2$/Vs) | $V_{on}$(V) |
|---------|-----------------------------------|-------------|
| 3.2 | 29.1 | -4.6 |
| 3.7 | 26.2 | -3.6 |
| 4.0 | 27.1 | -2.7 |
| 4.2 | 28.2 | -2.4 |
| 4.4 | 23.5 | -2.1 |

FIG. 3 shows the transfer characteristic curves of TFTs with different InZnO semiconductor layer thincknesses, prepared at a constant Opp of 4.0%. Table 3 shows electrical parameters of TFTs with different InZnO semiconductor layer thickness deposited at 4.0% Opp. Based on the extracted electrical parameters as listed in Table 3, TFTs with good performance can be obtained in the InZnO thickness (t) range of 5 nm < t < 10 nm. TFTs with greater than or equal to about 5 nm InZnO exhibit low mobility, however, TFTs with greater than or equal to about 10 nm InZnO exhibity higher negative turn-on voltage.

**Table 3.**

| InZnO thickness (nm) | Field-effect mobility (cm$^2$/Vs) | $V_{on}$(V) |
|----------------------|-----------------------------------|-------------|
| 5 | 15.8 | -2.48 |
| 7.5 | 32.2 | -2.92 |
| 10 | 31.9 | -4.2 |
| 12.5 | 31.4 | -5.1 |

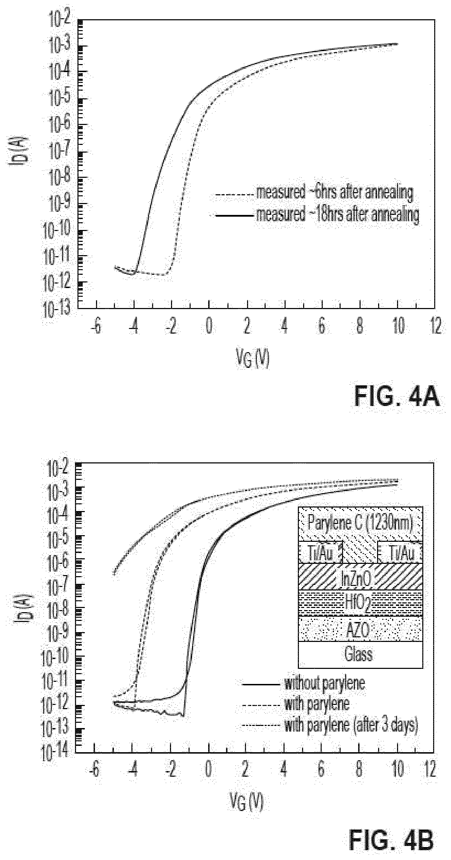

FIG. 4A shows the transfer characteristic curves of an InZnO TFT measured after 6 hours and 18 hours of post-fabrication annealing without passivation layer. The transfer curves show that the InZnO TFT is not stable over time. A passivation layer of Parylene-C (1200 nm) was also used to protect the InZnO layer from being exposed to atmospheric conditions. However, as it can be seen from FIG. 4B, the stability of InZnO TFT did not improve using a passivation layer.

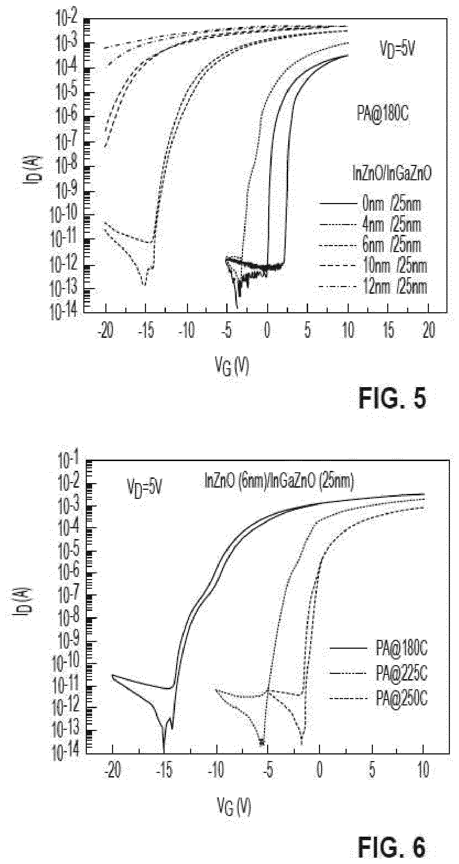

FIG. 5 shows the transfer characteristic curves of TFTs with InZnO-InGaZnO as a thin-film semiconductor bi-layer after post fabrication annealing at 180°C for 2 hours in air environment. Thickness of the InZnO layer was varied from 0 nm to 12 nm while keeping the InGaZnO layer thickness constant (25 nm). FIG. 5 shows that increase in InZnO layer thickness shifts the turn-on voltage of the TFT to larger negative voltage, which is not suitable for many electronic applications.

FIG. 6 shows the transfer characteristic curves of TFTs with InZnO (6nm)-InGaZnO (25 nm) as the thin-film semiconductor bi-layer and post-annealed at different temperatures (180°C, 225°C and 250°C) for 2 hours in air environment. FIG. 6 indicates that post-fabrication annealing at 250°C exhibits lower turn-on voltage compared to the TFTs annealed at lower temperature.

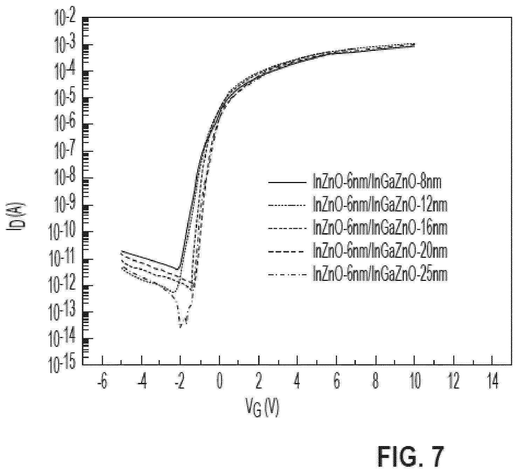

FIG. 7 shows the transfer characteristic curves of TFTs with InZnO-InGaZnO as the thin-film semiconductor bi-layer after post fabrication annealing at 250°C for 2 hours in air environment. Thickness of the InGaZnO layer was varied from 8 nm to 25 nm while keeping the InZnO layer thickness constant (6 nm). Table 4 shows electrical parameters of TFTs with the thin-film semiconductor bi-layer having 6 nm of InZnO and different thicknesses of InGaZnO. Based on the extracted electrical parameters as listed in Table 4, better performance is obtained with TFTs having InGaZnO thickness greater than or equal to about 16nm. Especially, TFTs with InGaZnO thickness greater than or equal to about 16nm shows higher mobility and lower negative turn-on voltage.

**Table 4.**

| InZnO thickness (nm) | InGaZnO thickness (nm) | Field-effect mobility (cm²/Vs) | $V_{on}$(V) |
|---|---|---|---|
| 6 | 8 | 20.9 | -2.0 |
| 6 | 12 | 22.5 | -2.2 |
| 6 | 16 | 21.7 | -1.4 |
| 6 | 20 | 22.9 | -1.3 |
| 6 | 25 | 23.7 | -1.4 |

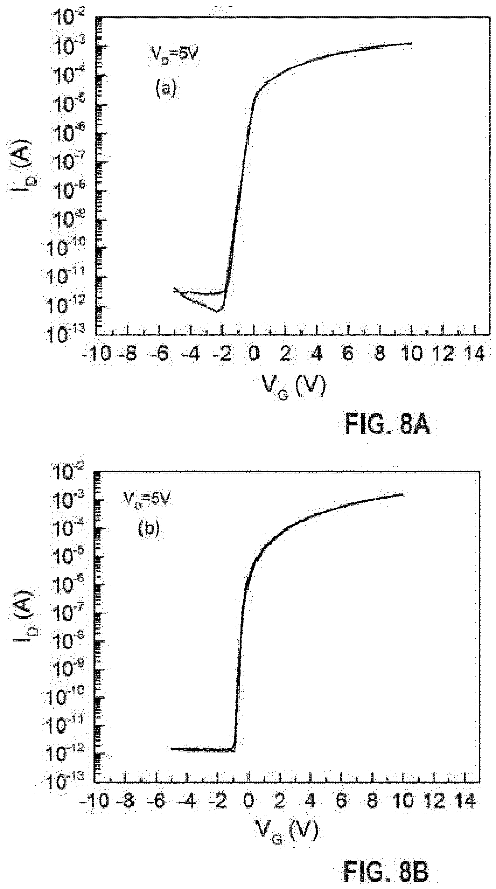

FIGs. 8A-B shows the transfer characteristic curves of TFTs with 8 nm InZnO and 25 nm InGaZnO as the thin-film semiconductor bi-layer. In FIG. 8B, the InZnO-InGaZnO film was annealed at 250°C before the source-drain electrode patterning and deposition. However, in FIG. 8A there was no such annealing of the InZnO-InGaZnO film. After source-drain patterning and deposition, both the samples were annealed at 250°C for 2 hours in air. FIG. 8A shows an unusual slope of the transfer curve in the gate voltage ($V_G$) range of -2V to 0.1V. This behavior may due to be the partial oxidation of the Ti-layer used for the source-drain electrode during the final annealing of TFTs. However, such behavior is not seen in case of the TFTs when the InZnO-InGaZnO film was annealed at 250°C before the source-drain electrodes patterning and deposition. Since both the samples were subjected to a final post-fabrication annealing at 250°C, it suggests that there is an oxygen transfer from the semiconductor layer to the Ti layer in case of FIG. 8A. The oxygen transfer from the semiconductor layer makes the Ti layer partially oxidized and increases the contact resistance between the semiconductor layer and the Ti/Au electrodes. However, this effect is minimized when the thin-film semiconductor bi-layer was pre-annealed before the source-drain electrode patterning and deposition.

Table 5 shows electrical parameters of TFTs having (a) no pre-annealed and (b) pre-annealed InZnO-InGaZnO based thin-film semiconductor bi-layer.

**Table 5.**

|  | Field-effect mobility (cm²/Vs) | $V_{on}$ (V) | $I_{on}/I_{off}$ | Subthreshold swing (mV/dec) |
|---|---|---|---|---|
| Without annealing of InZnO-InGaZnO layer before source-drain patterning | 27 | -2.0 | $10^9$ | 270 |
| With annealing of InZnO-InGaZnO layer before source-drain patterning | 35 | -0.89 | $10^9$ | 98 |

The performance of InZnO-InGaZnO TFT can be maximized under the following conditions:

Gate: Al-doped ZnO deposited at 160°C;
$HfO_2$ thickness: 55nm;
Deposition temperature: 160°C;
Post-annealing of $HfO_2$ before InZnO-InGaZnO deposition: 120°C in air;

InZnO (9:1) deposition condition:

Deposition pressure: 1.4mTorr;
Deposition temperature: Room Temperature;
Oxygen Partial Pressure: 4.0%;
InZnO thickness: 8 nm;

InGaZnO (1:1:1) deposition condition:

Deposition pressure: 1.4mTorr;
Deposition temperature: Room temperature;

Oxygen Partial Pressure: 3.2%;
IGZO thickness: 25nm;
Pre-annealing of InZnO-InGaZnO before source drain patterning: 250°C, 2 hours in air;
Source-Drain Ti/Au (10 nm/60 nm);
Post-fabrication annealing temperature: 250°C, 2 hours in air.

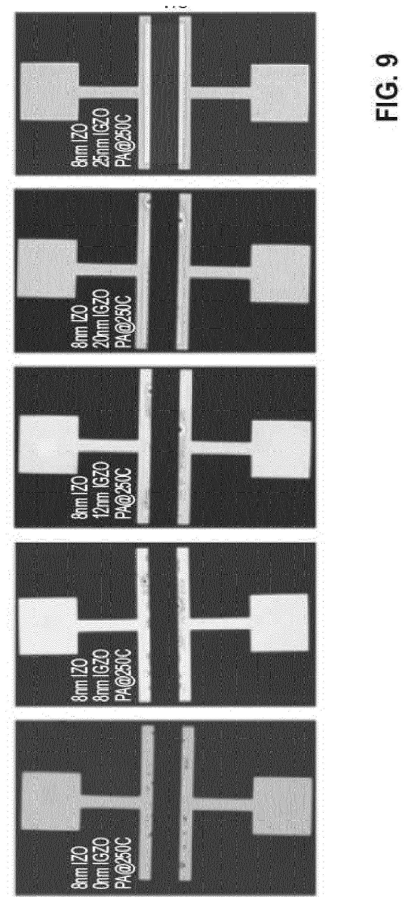

FIG. 9 shows optical images of InZnO-InGaZnO thin-film transistors having different thickness of the InGaZnO layer. It was found that some damage has occurred to the Ti/Au source drain layer after the devices were post annealed at 250°C. The damage to the source drain layer may be due to the oxidation of Ti layer during the post annealing process. However, no such damage was observed in case of the TFT with InGaZnO layer thickness of 25nm. Accordingly, the InZnO layer described herein has a thickness in a range of about 1 nm to about 10 nm (e.g., or about 3 nm to about 10 nm, or about 5 nm to about 10 nm). Similarly, the InGaZnO layer described herein has a thickness in a range of about 15 nm to about 50 nm (e.g., or about 15 nm to about 30 nm, about 20 nm to about 40 nm, about 20 nm to about 50 nm, about 25 nm to about 30 nm, about 25 nm to about 40 nm or about 25 nm to about 50 nm).

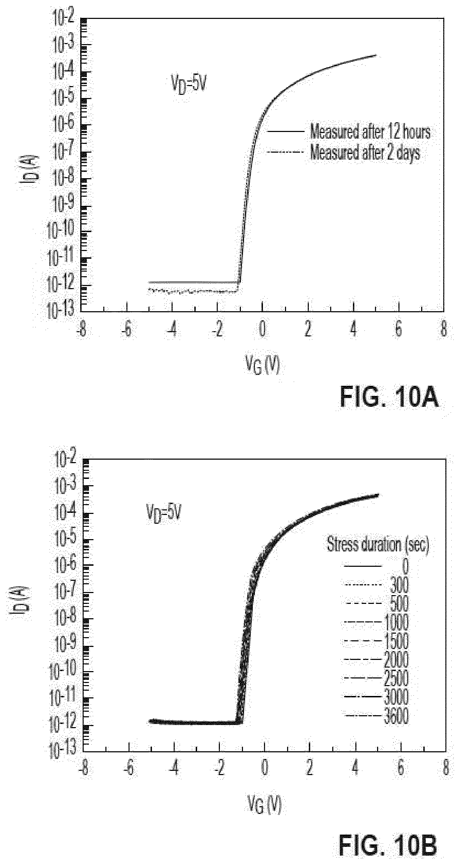

FIG. 10A shows the transfer characteristic curves of InZnO-InGaZnO TFT measured after 12 hours and 2 days of post-fabrication annealing without a passivation layer. The transfer curves show very stable behavior using InZnO-InGaZnO based thin-film semiconductor bi-layer compared to TFT using a single layer of InZnO as the semiconductor layer (as shown in FIG.4). FIG.10B shows the transfer characteristic curves of InZO/InGaZnO TFT measured under different durations of positive gate bias stress (PGBS). The PGBS measurements were performed by applying +5 V bias to the gate terminal of the TFT, while the drain and source terminals were maintained at 0V. The PGBS was applied up to 1 hour and transfer curves of the TFT were obtained after different durations. The TFT shows stable performance with a maximum change in $V_{on}$ of about -0.25V without having a passivation layer. A suitable passivation layer such as $SiO_2$, SiNx, $Al_2O_3$, $HfO_2$, $ZrO_2$, $TiO_2$, PVP, SU8, Parylene or a combination of them can be used to protect the TFT and to further improve the bias stability. The present disclosure can comprise at the least the following aspects.

Aspect 1. A method for forming a thin-film transistor, comprising, consisting of, or consisting essentially of: forming a thin-film gate electrode layer adjacent to a substrate; forming a thin-film gate insulator layer adjacent to the thin-film gate electrode layer and comprising hafnium oxide; forming a thin-film semiconductor bi-layer adjacent to the thin-film gate insulator layer, wherein the thin-film semiconductor bi-layer comprises a first layer and a second layer, wherein the first layer comprises indium zinc oxide with a ratio of indium to zinc in a range of about 19:1 to about 2:1 and the second layer comprises indium gallium zinc oxide with a ratio of indium to gallium to zinc of about 1:1:1, and wherein the first layer has a thickness of about 1 nm to about 10 nm and the second layer has a thickness of about 15 nm to about 50 nm; applying a pre-annealing process to one or more of the first layer or the second layer; and after applying the pre-annealing process, forming a thin-film source-drain electrode layer adjacent to the thin-film semiconductor bi-layer, wherein the thin-film gate electrode layer, the thin-film gate insulator layer, and the thin-film semiconductor bi-layer, and the second thin-film electrode layer are formed in a temperature range of about 20°C to about 250°C.

Aspect 2. The method of Aspect 1, wherein the thin-film gate electrode layer and the thin-film gate insulator layer are formed by atomic layer deposition in a temperature range of one or more of about 100°C to about 250°C or about 50°C to about 250°C.

Aspect 3. The method of any one of Aspects 1-2, wherein forming the thin-film semiconductor bi-layer is performed in a temperature range of about 20°C to about 30°C, and wherein the forming the thin-film gate insulator layer is performed in a temperature range of about 100°C to about 200°C.

Aspect 4. The method of any one of Aspects 1-3, wherein the ratio of indium to zinc is in a range of about 19:1 to about 6:1.

Aspect 5. The method of any one of Aspects 1-4, wherein the thin-film transistor has a field-effect mobility of in a range of about 10 $cm^2$/Vs to about 40 $cm^2$/Vs.

Aspect 6. The method of any one of Aspects 1-5, wherein the thin-film transistor has a negative turn on voltage in a range of about -1.5 V to about -0.5 V.

Aspect 7. The method of any one of claims 1-7, wherein the first layer is disposed between the second layer and the thin-film gate insulator layer.

Aspect 8. The method of any one of Aspects 1-7, wherein the pre-annealing process occurs prior to a post fabrication annealing, and wherein the pre-annealing process and the post fabrication annealing are performed at a temperature in a range of about 200°C to about 250°C.

Aspect 9. The method of any one of Aspects 1-8, wherein forming the thin-film semiconductor bi-layer comprises wet etching the first layer and the second layer.

Aspect 10. A device comprising, consisting of, or consisting essentially of: a substrate; a thin-film gate electrode layer adjacent to the substrate; a thin-film gate insulator layer adjacent to the thin-film gate electrode layer and comprising hafnium oxide; a thin-film semiconductor bi-layer adjacent to the thin-film gate insulator layer, wherein the thin-film semiconductor bi-layer comprises a first layer and a second layer, wherein the first layer comprises indium zinc oxide with a ratio of indium to zinc in a range of about 19:1 to about 2:1 and the second layer comprises indium gallium zinc oxide with a ratio of indium to gallium to zinc of about 1:1:1, and wherein the first layer has a thickness of about 1 nm to about 10 nm and the second layer has a thickness of about 15 nm to about 50 nm; and a thin-film source-drain electrode layer adjacent to the thin-film semiconductor bi-layer.

Aspect 11. The device of Aspect 10, wherein the thin-film source-drain electrode layer comprises a first conductive layer adjacent to the thin-film semiconductor bi-layer and a second conductive layer adjacent to the first conductive layer, wherein the first conductive layer has a first work function and the second layer has a second work function, wherein the first work function has a value that is the same or within about 20 percent greater than the second work function.

Aspect 12. The device of any one of Aspects 10-11, wherein the thin-film source-drain electrode layer comprises a titanium layer adjacent to the thin-film semiconductor bi-layer and a gold layer adjacent to the titanium layer.

Aspect 13. The device of any one of Aspects 10-12, wherein the ratio of indium to zinc is in a range of about 19:1 to about 6:1.

Aspect 14. The device of any one of Aspects 10-13, wherein the thin-film gate electrode layer comprises aluminum-doped zinc oxide.

Aspect 15. The device of any one of Aspects 10-14, wherein the substrate comprises a flexible plastic material.

Aspect 16. A system comprising one or more thin-film transistors formed according to any one of the methods of Aspects 1-14.

**Definitions**

It is also to be understood that the terminology used herein is for the purpose of describing particular aspects only and is not intended to be limiting.

Throughout the description and claims of this specification, the word "comprise" and variations of the word, such as "comprising" and "comprises," means "including but not limited to," and is not intended to exclude, for example, other components, integers or steps. The term "comprising" can include the embodiments "consisting of' and "consisting essentially of." "Exemplary" means "an example of' and is not intended to convey an indication of a preferred or ideal embodiment. "Such as" is not used in a restrictive sense, but for explanatory purposes.

Unless defined otherwise, all technical and scientific terms used herein have the same meaning as commonly understood by one of ordinary skill in the art to which this disclosure belongs. In this specification and in the claims which follow, reference will be made to a number of terms which shall be defined herein.

As used herein, the term "combination" is inclusive of blends, mixtures, alloys, reaction products, and the like.

Ranges can be expressed herein as from one value (first value) to another value (second value). When such a range is expressed, the range includes in some aspects one or both of the first value and the second value. Similarly, when values are expressed as approximations, by use of the antecedent 'about,' it will be understood that the particular value forms another aspect. It will be further understood that the endpoints of each of the ranges are significant both in relation to the other endpoint, and independently of the other endpoint. It is also understood that there are a number of values disclosed herein, and that each value is also herein disclosed as "about" that particular value in addition to the value itself. For example, if the value "10" is disclosed, then "about 10" is also disclosed. It is also understood that each unit between two particular units are also disclosed. For example, if 10 and 15 are disclosed, then 11, 12, 13, and 14 are also disclosed.

As used herein, the terms "about" and "at or about" mean that the amount or value in question can be the designated value, approximately the designated value, or about the same as the designated value. It is generally understood, as used herein, that it is the nominal value indicated $\pm10\%$ variation unless otherwise indicated or inferred. The term is intended to convey that similar values promote equivalent results or effects recited in the claims. That is, it is understood that amounts, sizes, formulations, parameters, and other quantities and characteristics are not and need not be exact, but can be approximate and/or larger or smaller, as desired, reflecting tolerances, conversion factors, rounding off, measurement error and the like, and other factors known to those of skill in the art. In general, an amount, size, formulation, parameter or other quantity or characteristic is "about" or "approximate" whether or not expressly stated to be such. It is understood that where "about" is used before a quantitative value, the parameter also includes the specific quantitative value itself, unless specifically stated otherwise.

As used herein, the terms "optional" or "optionally" means that the subsequently described event or circumstance can or cannot occur, and that the description includes instances where said event or circumstance occurs and instances where it does not. For example, the phrase "optional additional additives" means that the additional additives can or cannot be included and that the description includes compositions that both include and do not include additional additives.

Disclosed are the components to be used to prepare the compositions of the disclosure as well as the compositions themselves to be used within the methods disclosed herein. These and other materials are disclosed herein, and it is understood that when combinations, subsets, interactions, groups, etc. of these materials are disclosed that while specific reference of each various individual and collective combinations and permutation of these compounds cannot be explicitly disclosed, each is specifically contemplated and described herein. For example, if a particular compound is disclosed and discussed and a number of modifications that can be made to a number of molecules including the compounds are discussed, specifically contemplated is each and every combination and permutation of the compound and the modifications that are possible unless specifically indicated to the contrary. Thus, if a class of molecules A, B, and C are disclosed as well as a class of molecules D, E, and F and an example of a combination molecule, A-D is disclosed, then even if each is not individually recited each is individually and collectively contemplated meaning combinations, A-E, A-F, B-D, B-E, B-F, C-D, C-E, and C-F are considered disclosed. Likewise, any subset or combination of these is also disclosed. Thus, for example, the sub-group of A-E, B-F, and C-E would be considered disclosed. This concept applies to all aspects of this application including, but not limited to, steps in methods of making and using the compositions of the disclosure. Thus, if there are a variety of additional steps that can be performed it is understood that each of these additional steps can be performed with any specific aspect or combination of aspects of the methods of the disclosure.

References in the specification and concluding claims to parts by weight of a particular element or component in a composition or article, denotes the weight relationship between the element or component and any other elements or components in the composition or article for which a part by weight is expressed. Thus, in a compound containing 2 parts by weight of component X and 5 parts by weight component Y, X and Y are present at a weight ratio of 2:5, and are present in such ratio regardless of whether additional components are contained in the compound.

A weight percent of a component, unless specifically stated to the contrary, is based on the total weight of the formulation or composition in which the component is included. As used herein the terms "weight percent," "wt%," and "wt. %," which can be used interchangeably, indicate the percent by weight of a given component based on the total weight of the composition, unless otherwise specified. That is, unless otherwise specified, all wt% values are based on the total weight of the composition. It should be understood that the sum of wt% values for all components in a disclosed composition or formulation are equal to 100.

Unless otherwise stated to the contrary herein, all test standards are the most recent standard in effect at the time of filing this application. Each of the materials disclosed herein are either commercially available and/or the methods for the production thereof are known to those of skill in the art. It is understood that the compositions disclosed herein have certain functions. Disclosed herein are certain structural requirements for performing the disclosed functions and it is understood that there are a variety of structures that can perform the same function that are related to the disclosed structures, and that these structures will typically achieve the same result.

Throughout this document, values expressed in a range format should be interpreted in a flexible manner to include not only the numerical values explicitly recited as the limits of the range, but also to include all the individual numerical values or sub-ranges encompassed within that range as if each numerical value and sub-range is explicitly recited. For example, a range of "about 0.1% to about 5%" or "about 0.1% to 5%" should be interpreted to include not just about 0.1% to about 5%, but also the individual values (e.g., 1%, 2%, 3%, and 4%) and the sub-ranges (e.g., 0.1% to 0.5%, 1.1% to 2.2%, 3.3% to 4.4%) within the indicated range. The statement "about X to Y" has the same meaning as "about X to about Y," unless indicated otherwise. Likewise, the statement "about X, Y, or about Z" has the same meaning as "about X, about Y, or about Z," unless indicated otherwise. The term "about" as used herein can allow for a degree of variability in a value or range, for example, within 10%, within 5%, or within 1% of a stated value or of a stated limit of a range, and includes the exact stated value or range. The term "substantially" as used herein refers to a majority of, or mostly, as in at least about 50%, 60%, 70%, 80%, 90%, 95%, 96%, 97%, 98%, 99%, 99.5%, 99.9%, 99.99%, or at least about 99.999% or more, or 100%. While "about" permits some tolerance, a person of ordinary skill in the art would read the specification in light of his knowledge and skill for guidance on the level of that tolerance, and be reasonably apprised to a reasonable degree the metes and bounds of the claims.

In this document, the terms "a," "an," or "the" are used to include one or more than one unless the context clearly dictates otherwise. The term "or" is used to refer to a nonexclusive "or" unless otherwise indicated. The statement "at least one of A and B" has the same meaning as "A, B, or A and B." In addition, it is to be understood that the phraseology or terminology employed herein, and not otherwise defined, is for the purpose of description only and not of limitation. Any use of section headings is intended to aid reading of the document and is not to be interpreted as limiting; information that is relevant to a section heading can occur within or outside of that particular section.

In the methods described herein, the acts can be carried out in any order without departing from the principles of the invention, except when a temporal or operational sequence is explicitly recited. Furthermore, specified acts can be carried out concurrently unless explicit claim language recites that they be carried out separately. For example, a claimed act of doing X and a claimed act of doing Y can be conducted simultaneously within a single operation, and the resulting process will fall within the literal scope of the claimed process.

The term "radiation" as used herein refers to energetic particles travelling through a medium or space. Examples of radiation are visible light, infrared light, microwaves, radio waves, very low frequency waves, extremely low frequency waves, thermal radiation (heat), and black-body radiation. The term "UV light" as used herein refers to ultraviolet light, which is electromagnetic radiation with a wavelength of about 10 nm to about 400 nm.

The term "cure" as used herein refers to exposing to radiation in any form, heating, or allowing to undergo a physical or chemical reaction that results in hardening or an increase in viscosity.

The term "coating" as used herein refers to a continuous or discontinuous layer of material on the coated surface, wherein the layer of material can penetrate the surface and can fill areas such as pores, wherein the layer of material can have any three-dimensional shape, including a flat or curved plane. In one example, a coating can be applied to one or more surfaces, any of which can be porous or nonporous, by immersion in a bath of coating material.

The term "surface" as used herein refers to a boundary or side of an object, wherein the boundary or side can have any perimeter shape and can have any three-dimensional shape, including flat, curved, or angular, wherein the boundary or side can be continuous or discontinuous. While the term surface generally refers to the outermost boundary of an object with no implied depth, when the term 'pores' is used in reference to a surface, it refers to both the surface opening and the depth to which the pores extend beneath the surface into the substrate.

As used herein, the term "polymer" refers to a molecule having at least one repeating unit and can include copolymers and homopolymers. The polymers described herein can terminate in any suitable way. In some aspects, the polymers can terminate with an end group that is independently chosen from a suitable polymerization initiator, -H, -OH, a substituted or unsubstituted $(C_1-C_{20})$hydrocarbyl (e.g., $(C_1-C_{10})$alkyl or $(C_6-C_{20})$aryl) interrupted with 0, 1, 2, or 3 groups independently selected from -O-, substituted or unsubstituted -NH-, and -S-, a poly(substituted or unsubstituted $(C_1-C_{20})$hydrocarbyloxy), and a poly(substituted or unsubstituted $(C_1-C_{20})$hydrocarbylamino).

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code can form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

All publications mentioned herein are incorporated herein by reference to disclose and describe the methods and/or materials in connection with which the publications are cited. The above description is intended to be illustrative, and not restrictive. For example, the above-described examples (or one or more aspects thereof) can be used in combination with each other. Other embodiments can be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features can be grouped together to streamline the disclosure. This should not be interpreted as intending that an unclaimed disclosed feature is essential to any claim. Rather, inventive subject matter can lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

**Claims**

1. A thin-film transistor comprising:

   a substrate;
   a thin-film gate electrode layer adjacent to the substrate;
   a thin-film gate insulator layer adjacent to the thin-film gate electrode layer and comprising hafnium oxide;
   a thin-film semiconductor bi-layer adjacent to the thin-film gate insulator layer, wherein the thin-film semiconductor bi-layer comprises a first layer and a second layer, wherein the first layer comprises indium zinc oxide with a ratio of indium to zinc in a range of about 19:1 to about 2:1 and the second layer comprises indium gallium zinc oxide with a ratio of indium to gallium to zinc of about 1:1:1, and wherein the first layer has a thickness of about 1 nm to about 10 nm and the second layer has a thickness of about 15 nm to about 50 nm; and
   a thin-film source-drain electrode layer adjacent to the thin-film semiconductor bi-layer.

**2.** The thin-film transistor of claim 1, wherein the thin-film source-drain electrode layer comprises a first conductive layer adjacent to the thin-film semiconductor bi-layer and a second conductive layer adjacent to the first conductive layer, wherein the first conductive layer has a first work function and the second layer has a second work function, wherein the first work function has a value that is the same or within about 20 percent greater than the second work function.

**3.** The thin-film transistor of any one of claims 1-2, wherein the thin-film source-drain electrode layer comprises a titanium layer adjacent to the thin-film semiconductor bi-layer and a gold layer adjacent to the titanium layer.

**4.** The thin-film transistor of any one of claims 1-3, wherein the ratio of indium to zinc is in a range of about 19:1 to about 6:1.

**5.** The thin-film transistor of any one of claims 1-4, wherein the thin-film gate electrode layer comprises aluminum-doped zinc oxide.

**6.** The thin-film transistor of any one of claims 1-5, wherein the substrate comprises a flexible plastic material.

**7.** A method for forming a thin-film transistor, comprising:

forming a thin-film gate electrode layer adjacent to a substrate;
forming a thin-film gate insulator layer adjacent to the thin-film gate electrode layer and comprising hafnium oxide;
forming a thin-film semiconductor bi-layer adjacent to the thin-film gate insulator layer, wherein the thin-film semiconductor bi-layer comprises a first layer and a second layer, wherein the first layer comprises indium zinc oxide with a ratio of indium to zinc in a range of about 19:1 to about 2:1 and the second layer comprises indium gallium zinc oxide with a ratio of indium to gallium to zinc of about 1:1:1, and wherein the first layer has a thickness of about 1 nm to about 10 nm and the second layer has a thickness of about 15 nm to about 50 nm;
applying a pre-annealing process to one or more of the first layer or the second layer; and
after applying the pre-annealing process, forming a thin-film source-drain electrode layer adjacent to the thin-film semiconductor bi-layer,
wherein the thin-film gate electrode layer, the thin-film gate insulator layer, and the thin-film semiconductor bi-layer, and the second thin-film electrode layer are formed in a temperature range of about 20°C to about 250°C.

**8.** The method of claim 7, wherein the thin-film gate electrode layer and the thin-film gate insulator layer are formed by atomic layer deposition in a temperature range of one or more of about 100°C to about 250°C or about 50°C to about 250°C.

**9.** The method of any one of claims 7-8, wherein forming the thin-film semiconductor bi-layer is performed in a temperature range of about 20°C to about 30°C, and wherein the forming the thin-film gate insulator layer is performed in a temperature range of about 100°C to about 200°C.

**10.** The method of any one of claims 7-9, wherein the ratio of indium to zinc is in a range of about 19:1 to about 6:1.

**11.** The method of any one of claims 7-10, wherein the thin-film transistor has a field-effect mobility of in a range of about 10 $cm^2$/Vs to about 40 $cm^2$/Vs.

**12.** The method of any one of claims 7-11, wherein the thin-film transistor has a negative turn on voltage in a range of about -1.5 V to about -0.5 V.

**13.** The method of any one of claims 7-12, wherein the first layer is disposed between the second layer and the thin-film gate insulator layer.

**14.** The method of any one of claims 7-13, wherein the pre-annealing process occurs prior to a post fabrication annealing, and wherein the pre-annealing process and the post fabrication annealing are performed at a temperature in a range of about 200°C to about 250°C.

**15.** The method of any one of claims 7-14, wherein forming the thin-film semiconductor bi-layer comprises wet etching the first layer and the second layer.

FIG. 1

FIG. 2

FIG. 3

FIG. 4A

FIG. 4B

FIG. 5

FIG. 6

FIG. 7

FIG. 8A

FIG. 8B

FIG. 9

FIG. 10A

FIG. 10B

# EP 3 790 057 A1

Europäisches
Patentamt

European
Patent Office

Office européen
des brevets

## EUROPEAN SEARCH REPORT

Application Number

EP 19 19 5950

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2009/034953 A1 (IDEMITSU KOSAN CO [JP]; YANO KOKI [JP] ET AL.) 19 March 2009 (2009-03-19) | 1-6 | INV. H01L29/786 H01L21/336 |
| A | * paragraph [0015] - paragraph [0016] *<br>* paragraph [0019] *<br>* paragraph [0023] *<br>* paragraph [0082] *<br>* table 2 *<br>* claims * | 7-15 | |
| X | US 2013/161608 A1 (YAMAZAKI SHUNPEI [JP]) 27 June 2013 (2013-06-27) * paragraph [0089] - paragraph [0090] *<br>* paragraph [0092] - paragraph [0093] *<br>* paragraph [0130] - paragraph [0132] *<br>* paragraph [0110] *<br>* paragraph [0125] * | 1-6 | |
| A | WO 2010/114529 A1 (HEWLETT PACKARD DEVELOPMENT CO [US]; KORTHUIS VINCENT C [US] ET AL.) 7 October 2010 (2010-10-07) * paragraph [0009] - paragraph [0010] *<br>* paragraph [0020] - paragraph [0021] * | 1-15 | TECHNICAL FIELDS SEARCHED (IPC)<br><br>H01L |
| A | US 2010/276682 A1 (YEH YUNG-HUI [TW] ET AL) 4 November 2010 (2010-11-04) * paragraph [0021] - paragraph [0024] * | 1-15 | |
| A | US 2017/200746 A1 (SU TONGSHANG [CN] ET AL) 13 July 2017 (2017-07-13) * paragraph [0023] - paragraph [0024] * | 1-15 | |
| A | US 2018/182783 A1 (QIN FANG [CN]) 28 June 2018 (2018-06-28) * paragraph [0006] * | 1-15 | |

-/--

The present search report has been drawn up for all claims

| Place of search | Date of completion of the search | Examiner |
|---|---|---|
| Berlin | 25 February 2020 | Hoffmann, Niels |

EPO FORM 1503 03.82 (P04C01)

page 1 of 2

Europäisches
Patentamt

European
Patent Office

Office européen
des brevets

**EUROPEAN SEARCH REPORT**

Application Number

EP 19 19 5950

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/256666 A1 (CHANG HUI-YU [TW] ET AL) 3 October 2013 (2013-10-03) * paragraph [0058] - paragraph [0059] * ----- | 1-15 | |
| A | US 2015/103977 A1 (ONO MASASHI [JP] ET AL) 16 April 2015 (2015-04-16) * paragraph [0044] - paragraph [0051] * * paragraph [0060] * * paragraph [0148] - paragraph [0149] * * paragraph [0162] * ----- | 1-15 | |
| A | US 2015/221508 A1 (KURITA SHINICHI [US] ET AL) 6 August 2015 (2015-08-06) * paragraph [0009] * ----- | 1-15 | |

TECHNICAL FIELDS
SEARCHED (IPC)

The present search report has been drawn up for all claims

| Place of search | Date of completion of the search | Examiner |
|---|---|---|
| Berlin | 25 February 2020 | Hoffmann, Niels |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 19 19 5950

This annex lists the patent family members relating to the patent documents cited in the above-mentioned European search report.
The members are as contained in the European Patent Office EDP file on
The European Patent Office is in no way liable for these particulars which are merely given for the purpose of information.

25-02-2020

| Patent document cited in search report | | Publication date | Patent family member(s) | | Publication date |
|---|---|---|---|---|---|
| WO 2009034953 | A1 | 19-03-2009 | JP | WO2009034953 A1 | 24-12-2010 |
| | | | TW | 200915579 A | 01-04-2009 |
| | | | WO | 2009034953 A1 | 19-03-2009 |
| US 2013161608 | A1 | 27-06-2013 | CN | 103999228 A | 20-08-2014 |
| | | | CN | 109065630 A | 21-12-2018 |
| | | | JP | 2013149965 A | 01-08-2013 |
| | | | JP | 2017017345 A | 19-01-2017 |
| | | | JP | 2018137468 A | 30-08-2018 |
| | | | JP | 2019192930 A | 31-10-2019 |
| | | | KR | 20140107451 A | 04-09-2014 |
| | | | SG | 11201504823Y A | 30-07-2015 |
| | | | TW | 201336077 A | 01-09-2013 |
| | | | TW | 201727912 A | 01-08-2017 |
| | | | US | 2013161608 A1 | 27-06-2013 |
| | | | US | 2014339555 A1 | 20-11-2014 |
| | | | US | 2016005878 A1 | 07-01-2016 |
| | | | WO | 2013094772 A1 | 27-06-2013 |
| WO 2010114529 | A1 | 07-10-2010 | US | 2012012840 A1 | 19-01-2012 |
| | | | WO | 2010114529 A1 | 07-10-2010 |
| US 2010276682 | A1 | 04-11-2010 | TW | 201039445 A | 01-11-2010 |
| | | | US | 2010276682 A1 | 04-11-2010 |
| US 2017200746 | A1 | 13-07-2017 | CN | 105576038 A | 11-05-2016 |
| | | | US | 2017200746 A1 | 13-07-2017 |
| US 2018182783 | A1 | 28-06-2018 | CN | 106158978 A | 23-11-2016 |
| | | | US | 2018182783 A1 | 28-06-2018 |
| | | | WO | 2018006441 A1 | 11-01-2018 |
| US 2013256666 | A1 | 03-10-2013 | TW | 201340329 A | 01-10-2013 |
| | | | US | 2013256666 A1 | 03-10-2013 |
| US 2015103977 | A1 | 16-04-2015 | JP | 5972065 B2 | 17-08-2016 |
| | | | JP | 2014003244 A | 09-01-2014 |
| | | | KR | 20150021051 A | 27-02-2015 |
| | | | TW | 201405832 A | 01-02-2014 |
| | | | US | 2015103977 A1 | 16-04-2015 |
| | | | WO | 2013190992 A1 | 27-12-2013 |
| US 2015221508 | A1 | 06-08-2015 | NONE | | |

EPO FORM P0459

For more details about this annex : see Official Journal of the European Patent Office, No. 12/82